# EUROPEAN PATENT APPLICATION

(11) **EP 4 776 766 A1**
(43) Date of publication of application: **15.07.2026**
(21) Application number: 25151161.4
(22) Date of filing: 10.01.2025
(51) Int. Cl.: H05K 7/20, H01L 23/473

(54) **APPARATUS FOR LIQUID COOLING AT LEAST ONE INTEGRATED CIRCUIT AND VEHICLE COMPRISING SUCH AN APPARATUS**

(71) Applicant: Alps Alpine Co., Ltd., Ota-ku, Tokyo 145-8501 (JP)
(72) Inventor: Surugiu, Florin, 417 55 Gothenburg (SE)
(74) Representative: Schmitt-Nilson Schraud Waibel Wohlfrom Patentanwälte Partnerschaft mbB

(57) **Abstract**

An aspect of the present invention relates to an apparatus (1) for liquid cooling at least one integrated circuit (IC1, IC2, IC3), comprising: at least one heat-conducting plate (10) configured to be in thermal contact with the at least one integrated circuit (IC1, IC2, IC3); a casing (20) to which the at least one heat-conducting plate (10) is attached, the casing (20) comprising: an inlet section (30) comprising an inlet (31) for receiving a cooling liquid (CL); a manifold section (40) that is tapered and configured to control a flow (F) of the cooling liquid (CL) from the inlet section (30) into the manifold section (40) and change a flow direction of the cooling liquid (CL) from a first direction (D1) from the inlet section (30) into the manifold section (40) to a second direction (D2) transverse to the first direction (D1), the first direction (D1) and the second direction (D2) being parallel to a principal plane (11) of the at least one heat-conducting plate (10); a flow input control section (50) comprising a plurality of solid flow input control segments (51) that form flow input passages (52) between them and are configured to control the flow (F) of the cooling liquid (CL) in the second direction (D2) from the manifold section (40) into a cooling section (60) of the casing (20); the cooling section (60) comprising a plurality of heat sink elements (61, 64) at least a part of which is in thermal contact with the at least one heat-conducting plate (10) and that are configured to transfer heat from the at least one heat-conducting plate (10) to the cooling liquid (CL) flowing from the flow input control section (50) through the cooling section (60); and an outlet section (70) comprising an outlet (71) for outputting the cooling liquid (CL) from the cooling section (60). Another aspect relates to a vehicle (1000) comprising such an apparatus (1).

## Description

The present invention relates to an apparatus for liquid cooling at least one integrated circuit and a vehicle comprising such an apparatus.

Vehicles include more and more electronic devices, such as electronic control units (ECU), that comprise one or more data processing units, such as CPUs or GPUs, including one or more integrated circuits. For a reliable operation of these electronic devices, it is important to provide a way to dissipate excessive heat generated by the one or more integrated circuits during operation efficiently.

Conventional cooling apparatuses are, for example, known in the art such as described in JP 2021-144978 A. In JP 2021-144978 A, a heat generating element cooling device that can reduce the pressure loss in an inlet side header portion and an outlet side header portion and cool a plurality of discretely arranged heating elements is provided. The cooling device comprises: An inlet side header portion that includes a plurality of first tapering sections whose cross-sectional areas become continuously smaller as a distance from a refrigerant inlet increases, and a second tapering section with a smaller change in cross-sectional area than the first tapering section, an outlet side header portion that includes a plurality of third tapering sections whose cross-sectional areas become continuously smaller as a distance from a refrigerant outlet increases, and a fourth tapering section in which a change in the cross-sectional area is smaller than that of the third tapering section. The cooling apparatus is capable to cool an integrated circuit chip on one side of a housing.

Therefore, it is an object of the present invention to provide an improved apparatus for liquid cooling at least one integrated circuit and a vehicle comprising such an apparatus.

The present disclosure relates to an apparatus for liquid cooling at least one integrated circuit and a vehicle comprising such an apparatus according to the appended claims. Embodiments are disclosed in the respective dependent claims.

An aspect of the present invention relates to an apparatus for liquid cooling at least one integrated circuit, comprising: at least one heat-conducting plate configured to be in thermal contact with the at least one integrated circuit; a casing to which the at least one heat-conducting plate is attached, the casing comprising: an inlet section comprising an inlet for receiving a cooling liquid; a manifold section that is tapered and configured to control a flow of the cooling liquid from the inlet section into the manifold section and change a flow direction of the cooling liquid from a first direction from the inlet section into the manifold section to a second direction transverse to the first direction, the first direction and the second direction being parallel to a principal plane of the at least one heat-conducting plate; a flow input control section comprising a plurality of solid flow input control segments that form flow input passages between them and are configured to control the flow of the cooling liquid in the second direction from the manifold section into a cooling section of the casing; the cooling section comprising a plurality of heat sink elements at least a part of which is in thermal contact with the at least one heat-conducting plate and that are configured to transfer heat from the at least one heat-conducting plate to the cooling liquid flowing from the flow input control section through the cooling section; and an outlet section comprising an outlet for outputting the cooling liquid from the cooling section.

The apparatus according to the invention provides a more efficient way of liquid cooling at least one integrated circuit. The apparatus provides the beneficial effects that a particularly even flow of a cooling liquid can be achieved for the most part in the cooling section or in the entire cooling section. Therefore, uniformity of the cooling surface and performance on the at least one heat-conducting plate can be improved.

Furthermore, the flow of the cooling liquid is customizable to match the location of the at least one integrated circuit on a PCB, for example, thereby making liquid cooling of at least one integrated circuit more flexible and more efficient. The apparatus for example allows for defining different flow zones or cooling regions along the at least one heat-conducting plate.

Moreover, the apparatus may be provided in a particularly compact shape and/or in a cost-efficient manner.

According to an embodiment, the inlet and the outlet for the cooling liquid are each openings and/or passages arranged at the casing. Via the inlet, the cooling liquid may be introduced into the inlet section of the apparatus. Via the outlet, the cooling liquid may leave the apparatus. The inlet and the outlet may each be arranged at a side of the casing. They may each be arranged at different sides of the casing. They may be arranged at the same side of the casing such that an inlet direction of the cooling liquid at the inlet is substantially parallel to an outlet direction of the cooling liquid at the outlet.

According to an embodiment, the at least one heat-conducting plate is, or is at least a part of, a wall and/or cover of the casing. The at least one heat-conducting plate may be a sealing of the casing. The at least one heat-conducting plate may cover at least the cooling section. The at least one heat-conducting plate may be an integral part of the casing of the apparatus, or a separate element. The at least one heat-conducting plate may be mounted to the casing by screws and corresponding mounting holes in the casing or by an adhesive. The at least one heat-conducting plate may comprise a heat-conducting material.

According to an embodiment, the principal plane of the at least one heat-conducting plate corresponds to the main extension of the plate structure, e.g. a horizontal plane of extension of the at least one heat-conducting plate (when the casing is placed on ground). It may be a plane parallel to the bottom of the casing.

Herein, the expression "in thermal contact with" or "in thermal contact to" may include that two components are in direct contact with each other, for example by attaching or mounting one component to the other by using screws or by pressing them against each other, and/or that two components are indirectly in contact, for example via a thermal interface material (TIM), such as a heat-conducting glue, paste, resin or other heat-conducting elements between the two components, so that heat from one of the components to the other can be transferred.

For example, the at least one integrated circuit may be comprised by a chip package on a PCB. The chip package (with or without a PCB) may be attached to the at least one heat-conducting plate by a thermal interface material (TIM), particularly a heat-conducting glue or adhesive.

According to an embodiment, the manifold section is downstream from the inlet section. The flow input control section is downstream from the manifold section. The cooling section is downstream from the flow input control section. The outlet section is downstream from the cooling section.

According to an embodiment, the inlet section, the manifold section, the flow input control section, the cooling section and the outlet section are recesses in the casing. The sections may be formed in the casing by injection moulding or die casting.

According to an embodiment, the casing may comprise a polymeric material or metallic material. The casing may also comprise a heat-conducting material. The casing can be manufactured from copper, aluminium or other thermal conductive materials.

According to an embodiment, the first direction and the inlet direction of the cooling liquid at the inlet are spaced parallel to each other. The inlet section may extend from the inlet to the manifold section and may have at least two kinks or bends.

According to an embodiment, the second direction may substantially be perpendicular to the first direction. It may additionally be substantially perpendicular to the inlet direction.

According to an embodiment, the second direction may substantially be perpendicular to the outlet direction.

According to an embodiment, the second direction may be substantially perpendicular to the first direction, the inlet direction and the outlet direction. This allows for a quite compact shape of the apparatus so that the apparatus can be used in very limited spaces.

According to an embodiment, the inlet section further comprises an expansion chamber configured to homogenize the pressure over time of the cooling liquid from the inlet. The expansion chamber may result in an increased protection of sealing elements, such as an O-ring, from sudden pressure changes in the flow of the cooling liquid, particularly at the inlet section.

According to an embodiment, at least one side wall of the manifold section has a gradually tapered shape along the first direction. The manifold section particularly provides an even distribution of the cooling liquid from the inlet section towards the flow input control section. The at least one side wall may be a vertical wall of the casing. It may particularly be a part of a side wall of the casing.

According to an embodiment, the at least one side wall of the manifold section has alternately straight and sloped sections along the first direction. This ensures that flow of cooling liquid along the first direction can be changed to a second direction towards the flow input control section that is substantially perpendicular to the first direction. Thereby, a particularly compact design of the apparatus is also possible.

According to an embodiment, a respective slope angle between adjacent sloped and straight sections varies along the first direction. The slope angle may be in a range from about 120° to about 170°. By varying the slope angle, the cooling liquid flowing towards the flow input control section along the second direction can obtain different flow rates. By varying the slope angle, the flow of the cooling liquid can be controlled and adjusted as technically required, for example by the distribution of integrated circuits on a PCB to be cooled, along the first and/or second direction.

According to an embodiment, the lengths of the straight and/or sloped sections may vary along the first direction. By varying the length, the flow of the cooling liquid can be controlled and adjusted as technically required along the first and/or second direction.

According to an embodiment, the flow input control segments of the plurality of flow input control segments are arranged at a varying distance one after the other along the first direction. By varying the distance, the flow of the cooling liquid in the second direction can be controlled and adjusted along the first direction as technically required.

According to an embodiment, the plurality of flow input control segments includes pillar-like or wall-like elements. These elements may have substantially cuboid shape.

According to an embodiment, the flow input control segments of the plurality of flow input control segments have varying widths in the first direction along the first direction and/or varying thicknesses in the second direction along the first direction.

According to an embodiment, at least one of the plurality of flow input control segments has an edge curvature, in particular an edge fillet. An edge curvature can affect and control the flow of the cooling liquid in the second direction into the cooling section.

According to an embodiment, at least one of the plurality of flow input control segments has at least one flow redirecting face that is slanted with respect to the second direction of the cooling liquid. Slanting a face or side of the flow input control segments can affect and control, particularly redirect, the flow of the cooling liquid in the second direction. The flow redirecting face may for example be the side or face of a flow input control segment that faces or is opposite to the at least one tapering side wall of the manifold section. The redirecting face may also be one of the other sides or faces of a flow input control segment. The redirecting face may be angled with respect to a line along the second direction.

According to an embodiment, at least one of the plurality of flow input control segments is integrally formed with the casing.

According to an embodiment, the flow input passages may be channels that respectively extend between adjacent ones of the plurality of flow input segments in the second direction.

According to an embodiment, the flow input passages of the flow input control section have varying width and/or length along the first direction. By varying the width and/or length, the flow of the cooling liquid in the second direction into the cooling section can be controlled and adjusted along the first direction as technically required.

According to an embodiment, at least one of the flow input passages of the flow input control section has varying width along the second direction. According to an embodiment, at least one of the flow input passages is tapered. The at least one flow input passage may be tapered or widen up in the second direction. A flow input passage having varying width in the second direction can change the flow rate of the cooling liquid towards the cooling section in the second direction, leading to a flow adjustment in the second direction.

According to an embodiment, at least one of the flow input passages is arranged at least in part opposite to one of the sloped sections of the manifold section. The at least one flow input passage may for the most part be arranged opposite to a respective one of the sloped sections. A part of the at least one flow input passage may be opposite to a straight section adjacent to the respective sloped section. This arrangement of the at least one flow input passage ensures that the flow of the cooling liquid can be guided or redirected from the first direction to the second direction through the flow input passage.

According to an embodiment, at least one of the flow input control segments is arranged at least in part opposite to one of the straight sections of the manifold section. The at least one flow input control segment may for the most part be arranged opposite to a respective one of the straight sections. A part of the at least one flow input control segment may be opposite to a sloped section adjacent to the respective straight section. This arrangement of the at least one flow input control segment ensures that the flow of the cooling liquid can be guided or redirected from the first direction to the second direction through an adjacent flow input passage past the at least one flow input control segment.

According to an embodiment, the distances between straight sections and respective opposite flow input control segments varies along the first direction.

According to an embodiment, the cooling section has at least two cooling regions that extend parallel to the principal plane of the at least one heat-conducting plate, wherein one of the at least two cooling regions is structured such that the cooling liquid flowing through the cooling region obtains a higher flow rate than cooling liquid flowing in the other one of the at least two cooling regions. The at least two cooling regions are further configured for cooling a respective one of at least two integrated circuits that have different heat generation during operation. Thus, for example, an integrated circuit with the highest heat generation during operation of a plurality of integrated circuits on a PCB can be arranged above the cooling region with the highest flow rate of the cooling liquid. The apparatus may provide an optimized heat dissipation.

According to an embodiment, the cooling section further comprises a cooling chamber in which the plurality of heat sink elements is arranged and in which a plurality of turbulent flow segments may additionally be arranged to cause or increase a turbulent flow of the cooling liquid in the cooling chamber.

For example, by having some of the heat sink elements (e.g. pins) on the heat-conducting plate and some as part of the main body/casing, a gap between each heat sink element and its neighbours may be controlled. By having a reduced gap the cooling liquid flow velocity will be higher in that area compared to areas with larger gap. According to an embodiment, by arranging the heat sink elements in a chess layout, a turbulent flow may be achieved.

The plurality of turbulent flow segments may protrude from the bottom of the casing through the cooling chamber, particularly towards the at least one heat-conducting plate. At least one of the plurality of turbulent flow segments has pin shape. At least one of the plurality of turbulent flow segments may be integrally formed with the casing.

According to an embodiment, the plurality of heat sink elements comprises at least one of heat-conducting pins, heat-conducting fins and heat-conducting discrete stacked objects, such as heat-conducting spheres and/or polyhedrons. At least one of the plurality of heat sink elements may be integrally formed with the casing or the at least one heat-conducting plate. At least one of the plurality of heat sink elements and the at least one heat-conducting plate may be separate parts.

According to an embodiment, the casing further comprises a flow output control section comprising a plurality of solid flow output control segments that form flow output passages and are configured to control the flow of the cooling liquid from the cooling section into the outlet section. The plurality of flow output control segments and flow output passages provides further control of the flow of the cooling liquid through the apparatus.

All advantages, features, embodiments and explanations with respect to the plurality of flow input control segments and flow input passages apply to the plurality of flow output control segments and flow output passages accordingly.

According to an embodiment, the flow output control section is downstream from the cooling section. The outlet section is downstream from the flow output control section.

According to an embodiment, the flow output control section is a recess in the casing. The section may be formed in the casing by injection moulding or die casting.

According to an embodiment, the flow output control segments of the plurality of flow output control segments are arranged at varying distance one after the other along the first direction opposite to the flow input control segments relative to the cooling section.

According to an embodiment, the flow output control segments of the plurality of flow output control segments have varying widths in the first direction along the first direction and/or varying thicknesses in the second direction along the first direction.

According to an embodiment, at least one of the plurality of flow output control segments has an edge curvature, in particular an edge fillet.

According to an embodiment, at least one of the plurality of flow output control segments has at least one flow redirecting face that is slanted with respect to the second direction of the cooling liquid.

According to an embodiment, at least one of the flow output control segments is integrally formed with the casing.

According to an embodiment, the flow output passages of the flow output control section have varying width and/or length along the first direction.

According to an embodiment, at least one of the flow output passages of the flow output control section has varying width along the second direction.

According to an embodiment, at least one of the flow output passages is tapered.

According to an embodiment, the outlet section further comprises an outlet chamber configured to homogenize the pressure of the cooling liquid before the cooling liquid is output at the outlet. Thus, the outlet chamber can slow down the cooling liquid and attenuate sudden pressure changes.

According to an embodiment, the apparatus comprises an O-ring to make the apparatus fluid-tight and the casing has a recess (so-called gland) in which the O-ring is arranged, wherein the recess extends around at least the cooling section. In a case in which FSW (Friction Stir Welding) or brazing is used, an O-ring is not required, since tightness can be ensured by the welding or brazing itself.

According to an embodiment, the apparatus has cuboid shape, particularly plate shape.

The cooling liquid used for liquid cooling by the apparatus may be water or any other liquid, such as a coolant or refrigerant, suitable for liquid cooling.

Another aspect of the present invention relates to a vehicle comprising an apparatus according to the present invention.

All features, embodiments, advantages and further explanations described herein with respect to the apparatus apply to the vehicle accordingly.

Embodiments of the apparatus as described herein and individual features may be combined to yield further embodiments.

In the following, aspects of the invention will be described with reference to the drawings. Aspects shown in the drawings may be combined to form further aspects.
- Fig. 1: shows a top-down view of a cross-section of an apparatus for liquid cooling at least one integrated circuit according to aspects and embodiments of the invention along a principal plane of the at least one heat-conducting plate.
- Fig. 2: shows perspective views of an apparatus for liquid cooling at least one integrated circuit according to an embodiment.
- Fig. 3: shows an exploded view of an apparatus for liquid cooling at least one integrated circuit according to an embodiment.
- Fig. 4: shows the flow of a cooling liquid through an apparatus for liquid cooling at least one integrated circuit according to an embodiment.
- Fig. 5: further shows the flow of the cooling liquid through the apparatus shown in Fig. 4.
- Fig. 6: shows the flow of a cooling liquid through an apparatus for liquid cooling at least one integrated circuit according to an embodiment, the flow forming several cooling regions in the cooling section.
- Fig. 7: shows the manifold section and flow input control section of an apparatus for liquid cooling at least one integrated circuit according to an embodiment and the flow of a cooling liquid through these sections.
- Fig. 8: shows different configurations of the flow input control segments of an apparatus for liquid cooling at least one integrated circuit according to one or more embodiments and the respective flow of a cooling liquid.
- Fig. 9: shows a vehicle according to an embodiment of the invention.

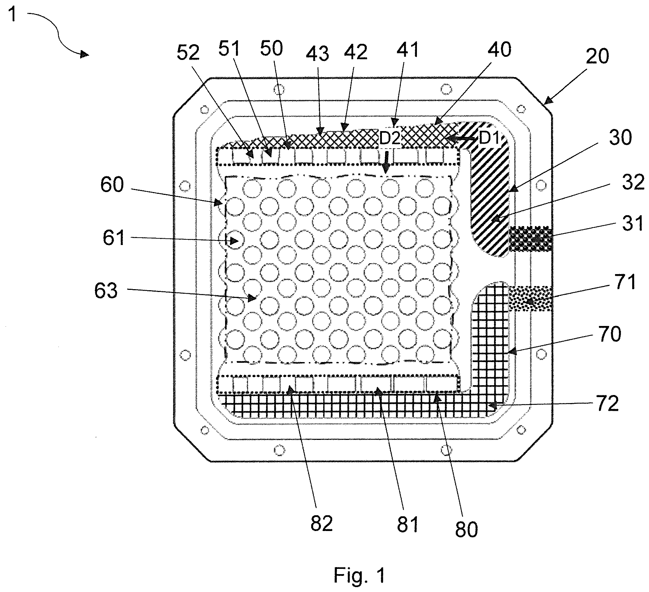

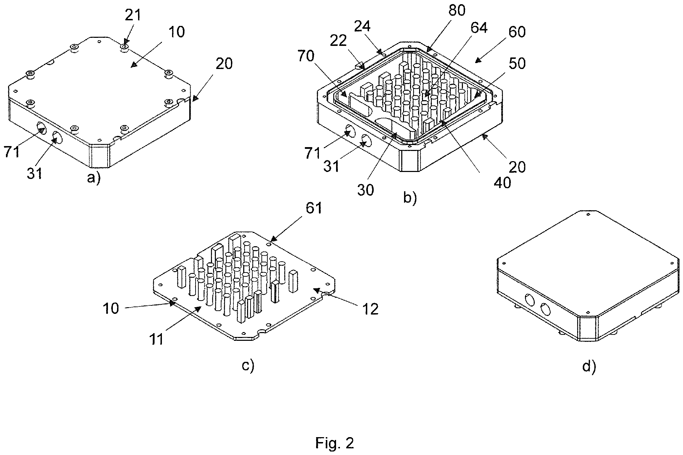

Fig. 1 shows a top-down view of a cross-section of an apparatus 1 for liquid cooling at least one integrated circuit (not shown) according to aspects and embodiments of the invention along a principal plane 11 of at least one heat-conducting plate 10 (cf. Fig. 2).

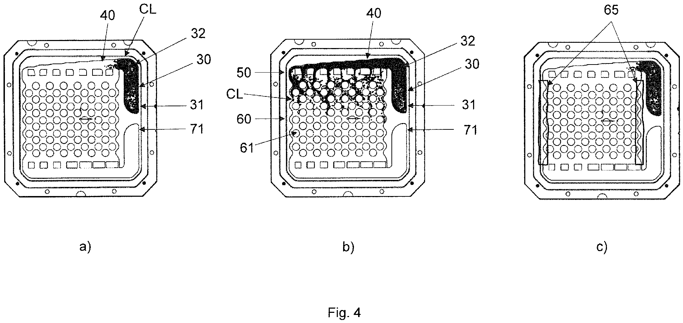

The apparatus 1 for liquid cooling at least one integrated circuit comprises at least one heat-conducting plate 10 configured to be in thermal contact with the at least one integrated circuit, and a casing 20 to which the at least one heat-conducting plate 10 is attached. The casing 20 comprises an inlet section 30 comprising an inlet 31 for receiving a cooling liquid CL (cf. Fig. 4), a manifold section 40 that is tapered and configured to control a flow F of the cooling liquid CL from the inlet section 30 into the manifold section 40 and change a flow direction of the cooling liquid CL from a first direction D1 from the inlet section 30 into the manifold section 40 to a second direction D2 transverse to the first direction D1. The first direction D1 and the second direction D2 are parallel to the principal plane 11 of the at least one heat-conducting plate 10. The casing 20 further comprises a flow input control section 50 (illustrated with dashed rectangle) comprising a plurality of solid flow input control segments 51 that form flow input passages 52 between them and are configured to control the flow F of the cooling liquid CL in the second direction D2 from the manifold section 40 into a cooling section 60 (dash-dotted rectangle) of the casing 20. The cooling section 60 comprises a plurality of heat sink elements 61 at least a part of which is in thermal contact with the at least one heat-conducting plate 10 and that are configured to transfer heat from the at least one heat-conducting plate 10 to the cooling liquid CL flowing from the flow input control section 50 through the cooling section 60. Furthermore, the casing 20 comprises an outlet section 70 comprising an outlet 71 for outputting the cooling liquid CL from the cooling section 60. According to an embodiment, arrangement and mounting of the heat sink elements 61 is "split" between the bottom part of the casing 20 and the heat-conducting plate 10 in a chess board pattern. Such pattern may be chosen to increase or improve manufacturability. Depending on the thickness of plate 10, a gap between heat sink elements (e.g. pins and/or fins) is not lower than, e.g., 5 mm. By overlapping the heat sink elements and splitting them as described above, the gap can be easily controlled without a manufacturing limitation.

The inlet section 30 may further comprise an expansion chamber 32 configured to homogenize the pressure over time of the cooling liquid CL coming from the inlet 31. In direction from the inlet 31 to the manifold section 40, the inlet section 30, particularly the expansion chamber 32, may have two kinks or bands, such as a right kink and a left kink.

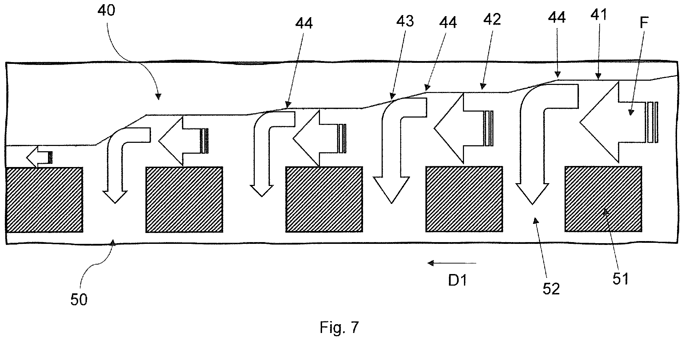

At least one side wall 41 of the manifold section 40 may have a gradually tapered shape along the first direction D1. The at least one side wall 41 of the manifold section 40 may have alternately straight and sloped sections 42, 43 along the first direction D1, shown in greater detail in Fig. 7.

As illustrated, according to one embodiment, in Fig. 7, at least one of the flow input passages 52 may be arranged at least in part opposite to one of the sloped sections 43 of the manifold section 40. At least one of the flow input control segments 51 may be arranged at least in part opposite to one of the straight sections 42 of the manifold section 50.

The first direction D1 corresponds to a main longitudinal extension of the manifold section 40.

The cooling section 60 may further comprise a cooling chamber 63 in which the plurality of heat sink elements 61 may be arranged and in which a plurality of solid turbulent flow segments 64 may be arranged to cause a turbulent flow of the cooling liquid CL in the cooling chamber 63. The turbulent flow segments 64 may be integrally formed with the casing 20, or may be separate elements.

According to an embodiment, the heat sink elements 61 may also act as turbulent flow segments and vice versa. For example, the turbulent flow segments 64 may also be heatsink elements mounted on the side of the bottom part of casing 20. Such embodiment may be advantageous to avoid manufacturing limitations due to too small gaps. If a gap between elements 61 is too small, manufacturing may be difficult or not possible. According to an embodiment, a chess layout (one element 61 on the side of plate 10, then the next one is element or segment 64 on the side of bottom part of casing 20, and so on) may be used. In Fig. 2 b) the heat-conducting plate 10 is not shown.

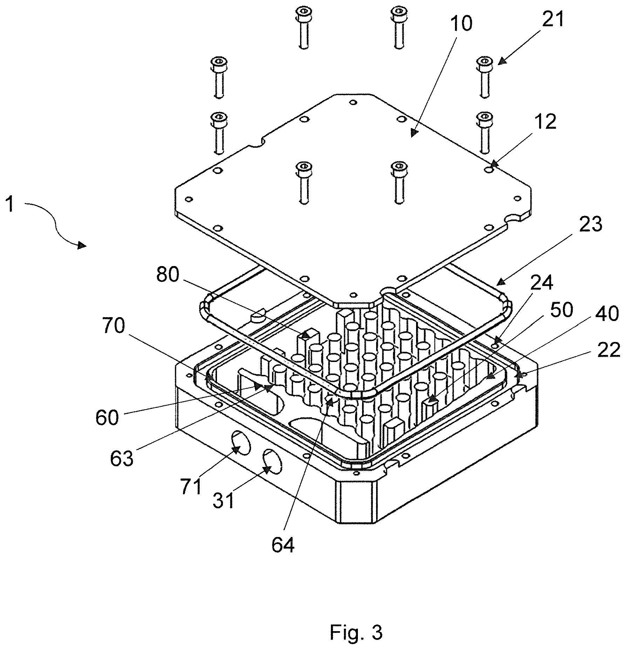

According to an embodiment, with reference to Fig. 3, to ensure a proper alignment of the chess layout and spacing of passages 52 and 82, locator elements (e.g. half pin/ dowel locator) may be arranged on the side of plate 10 and/or bottom part of casing 20. The provision of these elements may improve even and as designed spacing between elements 61 and 64, between segments 51 and between segments 81.

As a further mounting option beside screws and adhesive, also FSW (Friction Stir Welding) and brazing is possible. These two methods will work in particular if the plate 10 and casing 20 are both manufactured from metal. In a case in which cooling shall take place only on one side of the casing, one of the two parts, either plate 10 or casing 20 may be manufactured from plastic material, wherein in such a setup only mechanical fixation similar to screw fixation and O-ring will work.

The casing 20 may further comprise a flow output control section 80 (second dashed rectangle) comprising a plurality of solid flow output control segments 81 that form flow output passages 82 between them and are configured to control the flow F of the cooling liquid CL from the cooling section 60 into the outlet section 70. The flow output control segments 81 and flow output passages 82 may have similar or the same properties and/or features as the flow input control segments 51 and flow input passages 52. The flow output control segments 81 of the plurality of flow output control segments 81 may be arranged at varying distance one after the other along the first direction D1 opposite to the flow input control segments 51 relative to the cooling section 60. According to an embodiment, some of the flow output control segments 81 may be part of plate 10 and some part of the bottom part of casing 20, e.g. depending on the distance between the respective segments 81. If the distance is less than 5 mm, then it is advantageous that one or more of the segments be shifted to the opposite part of plate 10 or bottom part of casing 20, respectively.

According to an aspect, is it preferable if there is a minimum distance between the segments 51 and 81 or elements 61 and 64. If the distance is less than 5 mm, then the respective segment or element should be shifted to the opposite part of the casing, i.e. to either plate 10 or the other side of the casing 20. This then results in small gaps like 1 mm (for example in flow output control section 80). Where manufacturing by die casting is not possible, it is also possible to alternate the elements between plate 10 and the other side of the casing 20. This way it may be ensured that die cast manufacturability is possible, so that manufacturing costs can be significantly reduced.

There is also an option to control gaps between elements 61 and 64, since by optimizing the shape and pattern of elements 61 and 64 clearances of only 1 mm can be achieved which might be desired in case of custom cooling regions or increasing the thermal mass and flow velocity locally. This has also advantages in regards to die casting or injection molding, e.g. by CNC post processing.

The outlet section 70 may further comprise an outlet chamber 72 configured to homogenize the pressure of the cooling liquid CL before the cooling liquid CL is output at the outlet 71. The outlet chamber 72 may have two kinks or bends. In direction from the flow output control section 80 to the outlet 71, it may have a left kink and a right kink.

The inlet 31 and the outlet 71 may be located at the same side of the casing 20 of the apparatus. The first direction D1 may be similar as or identical to an inlet direction of the cooling liquid at the inlet 31. The second direction D2 may be substantially perpendicular to the first direction D1. An outlet direction of the cooling liquid at the outlet 71 may be substantially perpendicular to the second direction D2. The inlet direction and the outlet direction may be substantially parallel to each other.

Fig. 2 shows different partial perspective views of an apparatus 1 for liquid cooling at least one integrated circuit according to an embodiment. The apparatus 1 may be similar or identical to the apparatus shown in Fig. 1. Fig. 2a) shows a perspective view of the apparatus 1 with the at least one heat-conducting plate 10 being assembled and mounted on top of the casing 20 via screws 21. The inlet 31 and the outlet 71 are arranged at the same side of the casing 20. Fig. 2b) shows the apparatus 1 with the at least one heat-conducting plate 10 being not assembled. The casing 20 may comprise mounting holes 24 to receive the screws 21 when mounting the at least one heat-conducting plate 10 on the casing 20. The casing 20 may further comprise a recess 22 (so-called gland) in which an O-ring for making the apparatus 1 fluid-tight and sealing it may be placed. The recess 22 may extend around the inlet section 30, manifold section 40, flow input control section 50, cooling section 60, flow output control section 80 and outlet section 70. Fig. 2c) shows the at least one heat-conducting plate 10 of Fig. 2a) detached from the casing 20 and rotated (flipped) by 180°. The principal plane 11 of the at least one heat-conducting plate 10 may be or correspond to the bottom side of the at least one heat-conducting plate 10 that faces the cooling section when being assembled. The at least one heat-conducting plate 10 may comprise mounting through-holes 12 to receive screws when the at least one heat-conducting plate 10 is mounted on the casing 20. The at least one heat-conducting plate 10 may comprise the plurality of heat sink elements 61, such as pins. The heat sink elements 61 may be integral parts of the at least one heat-conducting plate 10, or separate elements attached to it.

According to some embodiments, the cooling can be done also either side of the casing 20, i.e. on the side of the heat conducting plate 10 or the opposite part of the casing 20 (here: the bottom part thereof), or on both sides, such as in a so-called dual PWB setup (sandwich setup; PWB: printed wiring board). In such sandwich setup, both, the plate 10 and opposite part of casing 20 are manufactured from thermal conductive material. Another option is to provide for the cooling only on the side of the plate 10 and have the casing 20 manufactured from plastics (e.g., not thermal conductive material, for lower production cost), for example when only one PWB is cooled. This setup will be the cheaper in manufacturing cost.

Fig. 3 shows an exploded view of an apparatus 1 for liquid cooling at least one integrated circuit according to an embodiment. The apparatus 1 shown in Fig. 3 is similar or identical to the one shown in Fig. 2. Fig. 3 further shows an O-ring 23 which may be placed in the recess 22 to make the apparatus 1 fluid-tight when the at least one heat-conducting plate 10 is mounted on the casing 20, for example by means of screws 21, the corresponding mounting through-holes 12 in the at least one heat-conducting plate 10 and mounting holes 24 in the casing 20.

Fig. 4 illustrates an exemplary flow of cooling liquid CL through an apparatus 1 for liquid cooling at least one integrated circuit according to an embodiment. In Fig. 4a), the cooling liquid CL (illustrated in black) flows through the inlet 31 into the expansion chamber 32 where it slows down and the pressure is homogenized. In Fig. 4b), the cooling liquid CL is illustrated to flow from the expansion chamber 32 into and through the manifold section 40 which guides and evens the cooling liquid flow along the length of the manifold section 40 in the first direction D1. This may balance the cooling liquid distribution to the flow input control section 50.

Fig. 4c) illustrates a further embodiment of the cooling section 60 within casing 20. It shows a waving shape on a side wall of casing 20 in the area of the cooling chamber 63 of the cooling section 60. Particularly, at least one side wall, or both side walls, of the cooling section 60 has at least in a part thereof a waving shape 65 in the area of the cooling chamber 63 in the flow direction of the cooling liquid in the cooling chamber 63. Advantageously, such waving shape prevents a laminar flow happening near the side walls. In case of a straight wall, there is the risk that cooling liquid will tend to "stick" to the even side of the wall creating and effect similar to magnetism, meaning the neighboring cooling liquid streams will be attracted to this laminar flow and therefore the flow inside cooling section 60 will be affected. In this case the cooling efficiency will be lower in a center of the cooling section 60 and also the flow balance is affected and more difficult to control via sections 40,50 and 80.

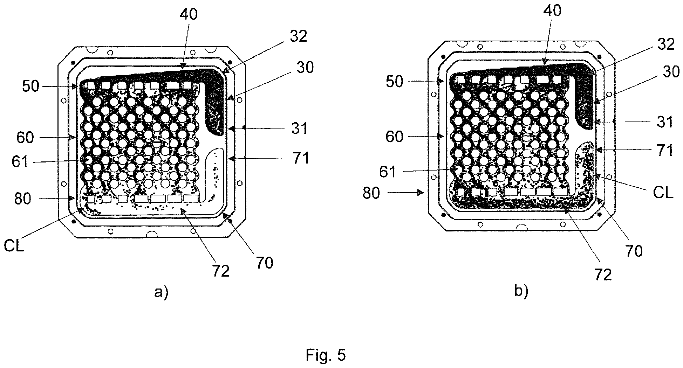

Fig. 5 further shows the proceeding flow of cooling liquid CL through the apparatus 1 shown in Fig. 4. In Fig. 5a), the cooling liquid CL flows from the manifold section 40 through the flow input passages 52 of the flow input control section 50 past the flow input control segments 51, which further regulates the pressure and flow, into the cooling section 60. Depending on the position and arrangement of the heat sink elements 61 and/or turbulent flow segments 64 (which may also act as heat sink elements, as described herein) in the cooling section 60, the geometry of each individual flow input control segment 51 and/or passage 52 can be customized to adjust and direct a higher or lower cooling liquid flow to the cooling section 60. This can be used, for example, in case higher cooling liquid flow is required in a specific area of the cooling section 60 due to placing an IC with high heat generation on a PCB that is brought into thermal contact with the at least one heat-conducting plate 10 or with the opposite part of casing 20. Such cooling surface of casing 20, as shown in an example in Fig. 2d), is according to some embodiments a flipped version of the heat-conducting plate 10, e.g. as shown in Fig. 2a).

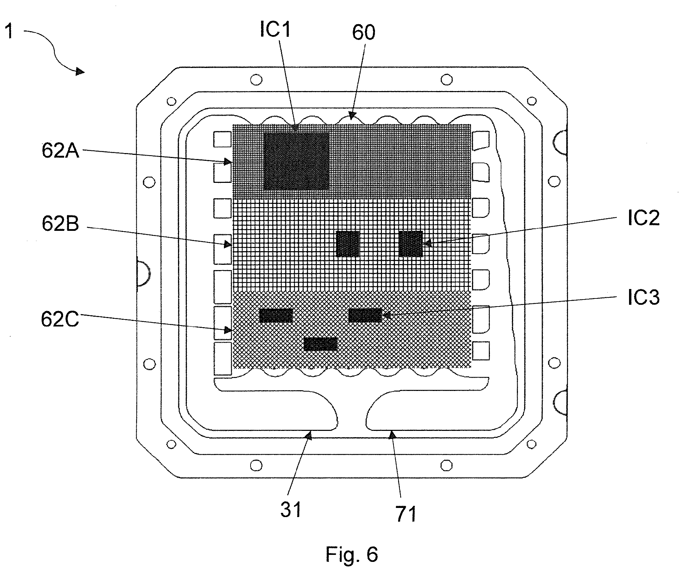

In this way, a cooling pattern may be provided on (or below, respectively) the at least one heat-conducting plate 10 based on the PCB layout: For example, a lower flow area where one or more ICs with lower heat generation are placed and a higher flow area where one or more ICs with higher heat generation are placed (see Fig. 6). In Fig. 5b), the cooling liquid CL flows through the cooling section 60. The cooling section 60 is the area where most of the heat transfer happens. The cooling liquid CL flows through the flow output passages 82 past the flow output control segments 81 into the flow output control section 80, which allows for further controlling the flow and the pressure before the cooling liquid enters the outlet chamber 72 of the outlet section 70. The outlet chamber 72 balances the velocity and pressure of the cooling liquid CL before it exits the apparatus 1 through the outlet 71.

Fig. 6 shows an exemplary flow of a cooling liquid through an apparatus 1 for liquid cooling at least one integrated circuit (IC1, IC2, IC3) according to an embodiment, the flow forming several cooling regions 62A, 62B, 62C in the cooling section 60 caused by the respective combination of inlet, manifold, flow control, cooling and outlet structure with the combination of sections 30, 40, 50, 60, 70 and their respective various elements as described herein. From top to bottom in Fig. 6, the distance between adjacent flow input control segments 51 decreases so that the flow rate of the cooling liquid CL flowing from the flow input control section 50 into the cooling section 60 decreases from top to bottom as well. Depending on the arrangement of the flow input control segments 51, a continuous transition in the flow rate from top to bottom can be achieved in the cooling section 60. Additionally or alternatively, regions with different flow rates which are constant in the respective region may be provided. There may be a cooling region 62A. In this region 62A, the cooling liquid flow may have the highest flow rate. ICs (such as illustrated with IC1) with a highest heat generation among the ICs to be cooled may be located on the heat-conducting plate 10 at (adjacent or above, respectively) region 62A. In region 62A, the cooling performance may be maximized. There may be a further cooling region 62B adjacent region 62A, as shown e.g. in Fig. 6. In region 62B, the cooling liquid flow rate may be smaller than in region 62A and ICs (IC2) with lower heat generation may be located on the heat-conducting plate 10 at (adjacent or above, respectively) this region. In region 62B, the cooling performance may be lower than in region 62A. There may also be a third cooling region 62C. In region 62C, the cooling liquid flow rate may be the lowest and ICs (IC3) with the lowest heat generation may be located on the heat-conducting plate 10 at (adjacent or above, respectively) this region. In region 62C, the cooling performance may be the lowest.

The cooling liquid flow may be customized to match the PCB-IC layout while making sure that an OEM demanded maximum flow rate requirement is not exceeded. For example, 50% of the total maximum flow rate may be guided in the cooling region 62A, 35% in the cooling region 62B and 15% may flow in the cooling region 62C.

The apparatus according to the invention provides the possibility to customize how the cooling liquid flows inside the apparatus.

Fig. 7 shows the manifold section 40 and flow input control section 50 of an apparatus 1 for liquid cooling at least one integrated circuit according to an embodiment and the flow F of a cooling liquid CL through these sections.

The side wall 41 of the manifold section 40 (e.g., forming an outer side wall of the casing 20) may have a gradually tapered shape along the first direction D1. The side wall 41 may have alternately straight and sloped sections 42, 43 along the first direction D1. A respective slope angle 44 between adjacent sloped and straight sections 43, 42 may vary along the first direction D1. Some or each of the flow input control segments 51 of the flow input control section 50 may be positioned opposite to a respective one of the straight sections 42. The flow input control segments 51 and respective opposite straight sections 42 form channels through which the flow F of the cooling liquid CL propagates. The clearance between each straight section 42 and opposite flow input control segment 51 may control the downstream cooling liquid volume flow F and pressure. The volume flow may thus vary with each flow input control segment 51 that is passed since the clearance may decrease from right to left.

Some or each of the flow input passages 52 may be positioned at least in part opposite to a respective one of the sloped sections 43. These flow input passages may additionally be arranged partially opposite to a straight section adjacent to the respective sloped section 43. That is, some of the flow input passages 52 may be offset in the first direction D1 with respect to the respective sloped section 43. The sloped sections 43 may divert or redirect the cooling liquid CL towards the flow input passages 52. The length of the straight sections 42 and/or sloped sections 43 along the first direction D1 may vary. Furthermore, the slope of the sloped sections 43 may vary.

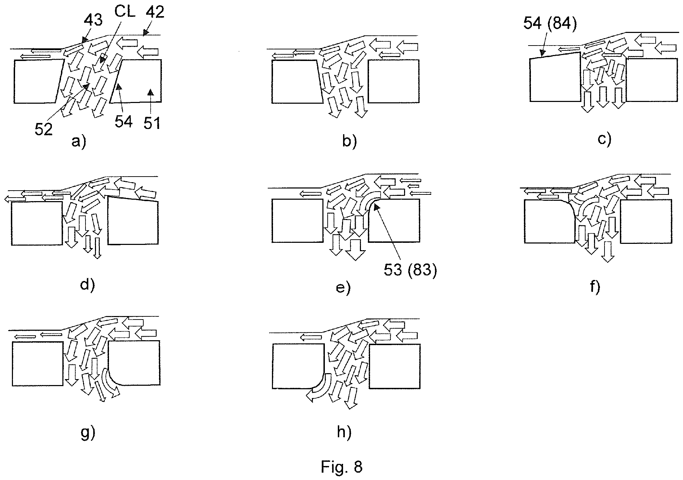

Fig. 8 shows different configurations of flow input control segments 51 of an apparatus 1 for liquid cooling at least one integrated circuit according to one or more embodiments and a respective flow F of cooling liquid CL.

In Fig. 8a), adjacent flow input control segments 51 may have opposite parallel slanted flow redirecting faces 54 which form a flow input passage 52 and direct the cooling liquid flow F in an inclined direction with respect to the first direction D1.

In Fig. 8b), one of two adjacent flow input control segments 51 may have a slanted flow redirecting face 54 which forms one side wall of a flow input passage 52 and directs the flow F to the inside of the respective flow input passage 52.

In Fig. 8c), one of two adjacent flow input control segments 51 may have a slanted flow redirecting face 54 which is opposite to one straight section 42 of the manifold section 40 and which is formed to narrow the channel width through the manifold section 40 in the first direction D1 after the flow input passage 52.

In Fig. 8d), one of two adjacent flow input control segments 51 may have a slanted flow redirecting face 54 which is opposite to one straight section 42 of the manifold section 40 and which is formed to narrow the channel width through the manifold section 40 in the first direction D1 in front of the flow input passage 52.

In Figs. 8e) to 8h), one of two adjacent flow input control segments 51 may have an edge curvature 53, particularly an edge fillet. The edge curvature 53 may contribute to accelerating and/or increasing the flow F around the edge curvature 53 and may have a flow directing function as illustrated.

The depiction of Fig. 8 is equally or analogously applicable to the flow output control segments 81 and flow output passages 82. The flow output control segments 81 may have flow redirecting faces 84 or edge curvatures 83 similar or identical to the ones of the flow input control segments 51. The flow output control segments 81 may be formed analogously to the flow input control segments 51 as described.

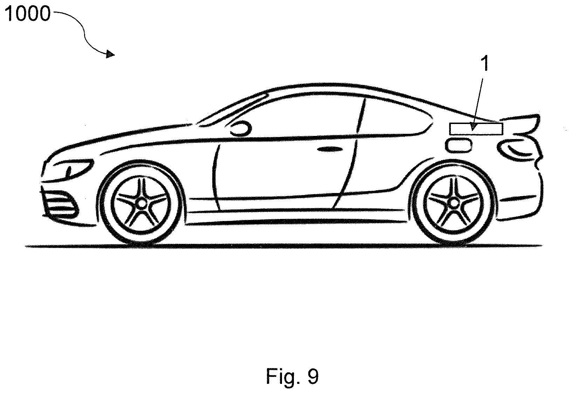

Fig. 9 shows a vehicle 1000 according to aspects of the invention. The vehicle 1000 may be a passenger car, in particular smart car. It comprises an apparatus 1 according to various embodiments as described herein.

A smart car may generally refer to a technologically advanced vehicle designed to enhance efficiency, safety, and convenience through features like connectivity, advanced driver-assistance systems (ADAS), and eco-friendly powertrains. It may refer to any car with intelligent systems like Al-powered navigation, autonomous driving capabilities, and real-time diagnostics. A smart car often integrates with smartphones and the internet, offering remote access, personalized settings, and over-the-air updates.

The apparatus 1 may for example be configured for cooling one or more integrated circuits of an electronic device, such as an electronic control unit (ECU) of the vehicle, which may be located in this embodiment at the trunk of the vehicle. In such application, the compact design of an apparatus according to aspects of the invention, as described herein, proves to be advantageous.

An ECU of a vehicle may generally refer to a control unit that may be configured to manage vehicle functions, such as engine performance, fuel injection, ignition timing, and emissions to ensure optimal efficiency and compliance with regulations. It may be configured to control gear shifting in automatic transmissions for smooth and efficient operation. It may be configured to control Anti-Lock Braking Systems (ABS) and electronic stability control for improved safety. It may manage electrical systems like lighting, wipers, windows, and door locks. It may be configured to activate airbags and seatbelt pretensioners during a collision. Furthermore, the ECU may be configured to manage vehicle connectivity, GPS navigation, and emergency communication systems, and/or entertainment/audio systems. The ECU may be configured to control the self-driving capabilities and/or features and surroundings detection using systems, such as LIDAR, cameras or other sensors.

### List of reference signs

- 1: apparatus
- 10: heat-conducting plate
- 11: principal plane
- 12: mounting hole in heat-conducting plate
- 20: casing
- 21: screw
- 22: recess for O-ring
- 23: O-ring
- 24: mounting hole in casing
- 30: inlet section
- 31: inlet
- 32: expansion chamber
- 40: manifold section
- 41: side wall of manifold section
- 42: straight section
- 43: sloped section
- 44: slope angle
- 50: flow input control section
- 51: flow input control segment
- 52: flow input passage
- 53: edge curvature
- 54: flow redirecting face
- 60: cooling section
- 61: heat sink element
- 62A, 62B, 62C: cooling region
- 63: cooling chamber
- 64: turbulent flow segment
- 65: waving shape
- 70: outlet section
- 71: outlet
- 72: outlet chamber
- 80: flow output control section
- 81: flow output control segment
- 82: flow output passage
- 83: edge curvature
- 84: flow redirecting face
- 1000: vehicle
- IC1, IC2, IC3: integrated circuit
- CL: cooling liquid
- F: flow
- D1: first direction
- D2: second direction

## Claims

1. An apparatus (1) for liquid cooling at least one integrated circuit (IC1, IC2, IC3), comprising:
at least one heat-conducting plate (10) configured to be in thermal contact with the at least one integrated circuit (IC1, IC2, IC3);
a casing (20) to which the at least one heat-conducting plate (10) is attached, the casing (20) comprising:
an inlet section (30) comprising an inlet (31) for receiving a cooling liquid (CL);
a manifold section (40) that is tapered and configured to control a flow (F) of the cooling liquid (CL) from the inlet section (30) into the manifold section (40) and change a flow direction of the cooling liquid (CL) from a first direction (D1) from the inlet section (30) into the manifold section (40) to a second direction (D2) transverse to the first direction (D1), the first direction (D1) and the second direction (D2) being parallel to a principal plane (11) of the at least one heat-conducting plate (10);
a flow input control section (50) comprising a plurality of solid flow input control segments (51) that form flow input passages (52) between them and are configured to control the flow (F) of the cooling liquid (CL) in the second direction (D2) from the manifold section (40) into a cooling section (60) of the casing (20);
the cooling section (60) comprising a plurality of heat sink elements (61, 64) at least a part of which is in thermal contact with the at least one heat-conducting plate (10) and that are configured to transfer heat from the at least one heat-conducting plate (10) to the cooling liquid (CL) flowing from the flow input control section (50) through the cooling section (60); and
an outlet section (70) comprising an outlet (71) for outputting the cooling liquid (CL) from the cooling section (60).

2. The apparatus (1) according to claim 1, wherein the inlet section (30) further comprises an expansion chamber (32) configured to homogenize the pressure over time of the cooling liquid (CL) from the inlet (31).

3. The apparatus (1) according to any one of the preceding claims, wherein at least one side wall (41) of the manifold section (40) has a gradually tapered shape along the first direction (D1).

4. The apparatus (1) according to claim 3, wherein the at least one side wall (41) of the manifold section (40) has alternately straight and sloped sections (42, 43) along the first direction (D1).

5. The apparatus (1) according to claim 4, wherein a respective slope angle (44) between adjacent sloped and straight sections (43, 42) varies along the first direction (D1).

6. The apparatus (1) according to any one of the preceding claims, wherein the flow input control segments (51) of the plurality of flow input control segments (51) are arranged at a varying distance one after the other along the first direction (D1); and/or
wherein at least one of the plurality of flow input control segments (51) has an edge curvature (53); and/or
wherein at least one of the plurality of flow input control segments (51) has at least one flow redirecting face (54) that is slanted with respect to the second direction (D2) of the cooling liquid (CL).

7. The apparatus (1) according to any one of the preceding claims, wherein the flow input passages (52) of the flow input control section (50) have varying width and/or length along the first direction (D1);
wherein at least one of the flow input passages (52) of the flow input control section (50) has varying width along the second direction (D2); and/or
wherein at least one of the flow input passages (52) is tapered.

8. The apparatus (1) according to any one of the claims 4 to 7, wherein at least one of the flow input passages (52) is arranged at least in part opposite to one of the sloped sections (43) of the manifold section (40); and/or
wherein at least one of the flow input control segments (51) is arranged at least in part opposite to one of the straight sections (42) of the manifold section (50).

9. The apparatus (1) according to any one of the preceding claims, wherein the cooling section (60) has at least two cooling regions (62A, 62B, 62C) that extend parallel to the principal plane (11) of the at least one heat-conducting plate (10), wherein one of the at least two cooling regions (62A, 62B, 62C) is structured such that the cooling liquid (CL) flowing through the cooling region (62A) obtains a higher flow rate than in the other one of the at least two cooling regions (62B, 62C), the at least two cooling regions (62A, 62B, 62C) being configured for cooling a respective one of at least two integrated circuits (IC1, IC2, IC3) that have different heat generation during operation.

10. The apparatus (1) according to any one of the preceding claims, wherein the cooling section (60) further comprises a cooling chamber (63) in which the plurality of heat sink elements (61) is arranged and/or in which a plurality of solid turbulent flow segments (64) is arranged to cause a turbulent flow of the cooling liquid (CL) in the cooling chamber (63), particularly wherein a side wall of the cooling section (60) has at least in a part thereof a waving shape in the area of the cooling chamber (63).

11. The apparatus (1) according to any one of the preceding claims, wherein the casing (20) further comprises a flow output control section (80) comprising a plurality of solid flow output control segments (81) that form flow output passages (82) and are configured to control the flow (F) of the cooling liquid (CL) from the cooling section (60) into the outlet section (70).

12. The apparatus (1) according to claim 11, wherein the flow output control segments (81) of the plurality of flow output control segments (81) are arranged at varying distance one after the other along the first direction (D1) opposite to the flow input control segments (51) relative to the cooling section (60); and/or
wherein at least one of the plurality of flow output control segments (81) has an edge curvature (83); and/or
wherein at least one of the plurality of flow output control segments (81) has at least one flow redirecting face (84) that is slanted with respect to the second direction (D2) of the cooling liquid (CL).

13. The apparatus according to claim 11 or 12, wherein the flow output passages (82) of the flow output control section (80) have varying width and/or length along the first direction (D1); and/or
wherein at least one of the flow output passages (82) of the flow output control section (80) has varying width along the second direction (D2); and/or
wherein at least one of the flow output passages (82) is tapered.

14. The apparatus (1) according to any one of the preceding claims, wherein the outlet section (70) further comprises an outlet chamber (72) configured to homogenize the pressure of the cooling liquid (CL) before the cooling liquid (CL) is output at the outlet (71).

15. A vehicle (1000), comprising an apparatus (1) according to any one of the preceding claims.
